# EUROPÄISCHE PATENTSCHRIFT

(11) **EP 2 146 558 B1**
(45) Veröffentlichungstag und Bekanntmachung des Hinweises auf die Patenterteilung: **17.08.2011**
(21) Anmeldenummer: 09162865.1
(22) Anmeldetag: 16.06.2009
(51) Int. Cl.: H05K 1/14, H05K 3/36, H05K 3/30, H05K 3/32

(54) **Befestigungsanordnung für ein Sicherheitsmodul**
Attachment assembly for a safety module
Agencement de fixation pour un module de sécurité

(30) Priorität: 15.07.2008 DE 102008033173
(43) Veröffentlichungstag der Anmeldung: 20.01.2010
(73) Patentinhaber: Fujitsu Technology Solutions Intellectual Property GmbH, 80807 München (DE)
(72) Erfinder: Kurten, Michael, 86153, Augsburg (DE)
(74) Vertreter: Epping - Hermann - Fischer

(56) Entgegenhaltungen:
- WO-A1-2009/014574
- WO-A1-2009/050779
- WO-A2-2008/022249
- US-A1- 2004 205 353
- US-A1- 2006 037 776
- US-A1- 2006 268 507
- US-A1- 2007 210 447
- US-A1- 2008 278 217

## Beschreibung

### Befestigungsanordnung für ein Sicherheitsmodul

Die Erfindung betrifft eine Befestigungsanordnung für ein Sicherheitsmodul, umfassend eine Systemkomponente eines zu sichernden elektronischen Geräts und ein Sicherheitsmodul, wobei das Sicherheitsmodul das zu sichernde elektronische Gerät eindeutig kennzeichnet.

Sicherheitsmodule zur Kennzeichnung zu sichernder elektronischer Geräte sind aus dem Stand der Technik bekannt. Insbesondere ist aus dem Standard "TCG PC Specific Implementation Specification for Conventional BIOS", Version 1.20, Revision 1.00 vom 13. Juli 2005 der Trusted Computing Group, Inc., erhältlich von http://www.trustedcomputinggroup.org/developers- /pc_client/specifications, ein Standard für so genannte Trusted Platform Modules (TPM) bekannt. Gemäß diesem Standard wird ein TPM Sicherheitsmodul entweder logisch oder physikalisch mit einem zu sichernden elektronischen Gerät verbunden. Eine Möglichkeit, eine physikalische Verbindung zwischen dem Sicherheitsmodul und der Systemkomponente herzustellen, besteht darin, das Sicherheitsmodul auf die Systemkomponente aufzulöten. Eine Möglichkeit, eine logische Verbindung zwischen dem zu sichernden elektronischen Gerät und dem Sicherheitsmodul herzustellen, besteht in der Verwendung kryptografischer Verfahren.

Da kryptografische Verfahren und Komponenten zu ihrer Durchführung teilweise Export- bzw. Importkontrollen unterliegen, ist es vorteilhaft, eine Systemkomponente eines zu sichernden elektronischen Geräts wahlweise mit oder ohne Sicherheitsmodul auszustatten. Gleichzeitig soll die im oben genannten Standard geforderte feste Verbindung zwischen dem zu sichernden elektronischen Gerät und einem eventuell installierten Sicherheitsmodul gewährleistet werden.

Die Patentschrift US-A-2006/0268507 zeigt ein Sicherheitsmodul aufgelötet oder in einer Steckverbindung untergebracht. Die Patentschrift US-A-2006/0037776 zeigt ein Platinenmodul, das auf eine systemplatine aufgesteckt und über eine Schraubverbindung gesichert wird.

Eine Aufgabe der vorliegenden Erfindung liegt darin, eine Befestigungsanordnung für ein Sicherheitsmodul zu beschreiben, die eine modulare Bauweise gestattet, ohne dabei auf eine feste Verbindung der Komponenten zu verzichten.

Die Aufgabe wird durch eine Befestigungsanordnung gemäß Anspruch 1 gelöst.

Gemäß einer Ausgestaltung umfasst die Befestigungsanordnung eine Systemkomponente eines zu sichernden elektronischen Geräts mit wenigstens einem Steckverbinder und wenigstens einer Befestigungsvorrichtung, ein in dem Steckverbinder aufgenommenes Sicherheitsmodul mit wenigstens einer Befestigungsöffnung, wobei das Sicherheitsmodul das zu sichernde elektronische Gerät eindeutig kennzeichnet, und ein durch die Befestigungsöffnung geführtes Befestigungsmodul, das durch eine gesicherte Verbindung mit der Befestigungsvorrichtung verbunden ist.

Durch die Verwendung eines Steckverbinders kann ein Sicherheitsmodul nachträglich auf einer Systemkomponente aufgesteckt werden. Durch die Verwendung eines durch die Befestigungsöffnung des Sicherheitsmoduls geführten und mit der Befestigungsvorrichtung gesichert verbundenen Befestigungsmittels kann das Sicherheitsmodul dauerhaft fest mit der Systemkomponente verbunden werden.

Der Grad der Sicherheit der Verbindung hängt im Wesentlichen von der Anforderungen an die Sicherung des Geräts statt. Soll bloß ein einfacher Diebstahl vermieden werden, reicht unter Umständen die Verwendung einer Schraube, die nicht mit handelsüblichen Werkzeugen gelöst werden kann. Sind die Anforderungen höher, wie beispielsweise bei kryptografischen Sicherheitssystemen, sollte die gesicherte Verbindung dagegen unlösbar ausgestaltet werden, das heißt eine Lösung der Verbindung nur mittels Zerstörung der Systemkomponente oder des Sicherheitsmoduls möglich ist.

Anspruchsgemäß umfasst das Befestigungsmittel einen Sicherheitsbefestiger, wobei zumindest zum Lösen des Sicherheitsbefestigers ein Spezialwerkzeug erforderlich ist. Durch das Erfordernis eines Spezialwerkzeugs zum Lösen des Befestigungsmittels wird ein einfaches Lösen des Sicherheitsmoduls durch Unbefugte unterbunden.

Gemäß einer vorteilhaften Ausgestaltung umfasst die Systemkomponente eine erste Leiterplatte mit einem darauf angeordneten Zentralprozessor. Gemäß einer weiteren vorteilhaften Ausgestaltung weist die erste Leiterplatte eine Aussparung auf und die Befestigungsvorrichtung umfasst einen durch die Aussparung geführten Abstandshalter. Gemäß einer weiteren vorteilhaften Ausgestaltung ist der Abstandshalter derart ausgestaltet, dass er bei einem Eindrehen des Befestigungsmittels in den Abstandshalter in der Aussparung blockiert und bei einem Versuch eines Ausdrehens des Befestigungsmittels aus dem Abstandshalter in der Aussparung durchdreht, sodass ein Lösung des Befestigungsmittels aus dem Abstandshalter verhindert wird.

Die Verwendung einer ersten Leiterplatte als Systemkomponente, beispielsweise eines Mainboards, mit einer Aussparung zur Aufnahme der Befestigungsvorrichtung ermöglicht einen einfachen Aufbau bzw. eine einfache und standardkonforme Fertigung der zu sichernden Systemkomponente. Wird ein Abstandshalter, der derart ausgestaltet ist, dass er sich beim Versuch eines Ausdrehens des Befestigungsmittels aus dem Abstandshalter in der Aussparung durchdreht, verwendet, wird auf einfache Weise eine Lösung des Befestigungsmittels verhindert.

Gemäß einer weiteren vorteilhaften Ausgestaltung umfasst das Sicherheitsmodul eine zweite Leiterplatte mit einem darauf angeordneten und verlöteten Trusted Platform Module. Ein Sicherheitsmodul in Form einer Leiterplatte mit einem darauf angeordneten und verlöteten Trusted Platform Module kann auf besonders einfache Weise hergestellt und bestückt werden.

Gemäß einer vorteilhaften Ausgestaltung umfasst der Sicherheitsbefestiger eine Schraube mit einem einseitigen Kraftangriff, wobei der einseitige Kraftangriff ein Einschrauben der Schraube in die Befestigungsvorrichtung ermöglicht und ein Lösen der Schraube aus der Befestigungsvorrichtung verhindert. Durch die Verwendung einer Schraube mit einem einseitigen Kraftangriff kann das Sicherheitsmodul in der Produktion mit standardkonformen Werkzeugen befestigt, jedoch nicht wieder gelöst werden.

Gemäß einer weiteren vorteilhaften Ausgestaltung umfasst der Sicherheitsbefestiger ein eine Pressschraube, wobei eine asymmetrische Gewindeform der Pressschraube ein Einschrauben der Pressschraube in die Befestigungsvorrichtung ermöglicht und ein Lösen der Schraube aus der Befestigungsvorrichtung verhindert. Die Verwendung von Pressschrauben ermöglicht eine besonders einfache Herstellung einer Verbindung, die nur mittels eines speziellen Presswerkzeugs zu lösen ist.

Gemäß einer weiteren vorteilhaften Ausgestaltung sind das Befestigungsmittel und die Befestigungsvorrichtung miteinander verklebt. Die Verwendung einer Verklebung zwischen dem Befestigungsmittel und der Befestigungsvorrichtung ermöglicht eine einfache Herstellung einer unlösbaren Verbindung.

Weitere Vorteile und Ausgestaltungen der Erfindung sind in den Patentansprüchen und den nachfolgend unter Bezugnahme auf Figuren beschriebenen Ausführungsbeispielen offenbart.

In den Figuren zeigen:
Figur 1 eine Befestigungsanordnung gemäß einer ersten Ausgestaltung,
Figur 2A und 2B eine Aufsicht auf und einen Querschnitt durch einen ersten Sicherheitsbefestiger,
Figur 3A und 3B eine Aufsicht auf und einen Querschnitt durch einen zweiten Sicherheitsbefestiger,
Figur 4 eine Befestigungsanordnung gemäß einer zweiten Ausgestaltung,
Figur 5A bis 5C Querschnitte durch eine Befestigungsvorrichtung und
Figur 6 eine Aufsicht auf einen dritten Sicherheitsbefestiger.

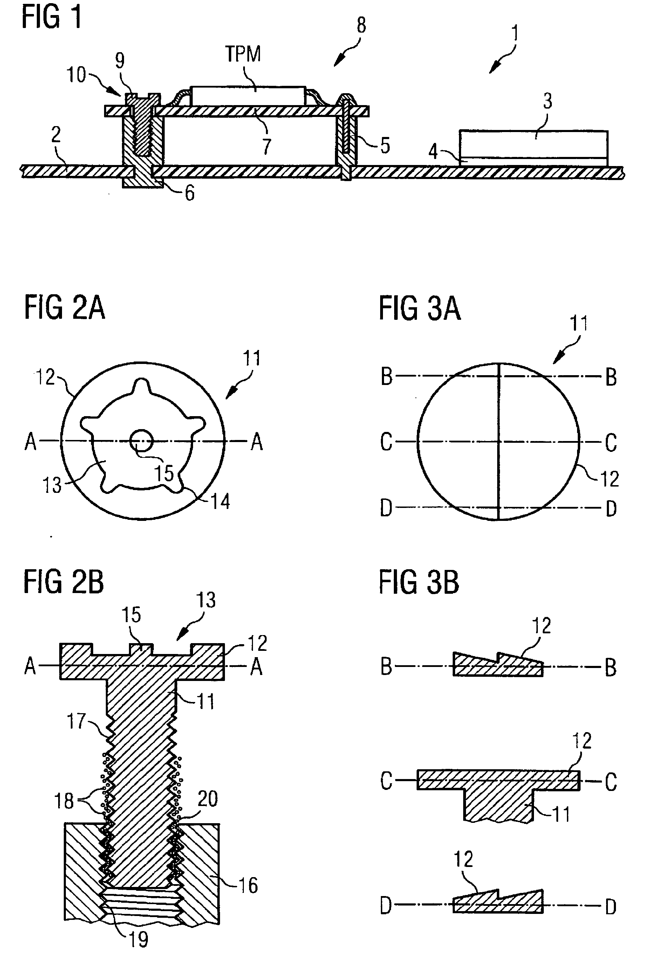

Figur 1 zeigt einen Querschnitt durch eine Befestigungsanordnung 1. Die Befestigungsanordnung 1 umfasst eine Systemkomponente eines zu sichernden elektronischen Geräts, beispielsweise eines Computers, in Form einer ersten Leiterplatte 2. Auf der ersten Leiterplatte 2 sind Komponenten des zu sichernden elektronischen Geräts angeordnet. Beispielsweise ist in der Figur 1 ein Zentralprozessor 3 dargestellt, der in einem Sockel 4 auf der ersten Leiterplatte 2 angeordnet ist. Des Weiteren ist auf der ersten Leiterplatte 2 ein Steckverbinder 5, beispielsweise in Form eines Pfostensteckverbinders, und eine Befestigungsvorrichtung 6, beispielsweise in Form eines Abstandshalters, angeordnet. Die Befestigungsvorrichtung 6 ist im Ausführungsbeispiel fest mit der ersten Leiterplatte 2 verbunden. Beispielsweise kann die Befestigungsvorrichtung 6 mit der Leiterplatte 2 verlötet, vernietet oder verklebt sein. Es ist jedoch auch die Befestigung unter Verwendung einer selbst verrastenden oder klemmenden Befestigungsvorrichtung 6 möglich, wie später anhand des zweiten Ausführungsbeispiels näher erläutert wird.

Über der ersten Leiterplatte 2 ist in der Befestigungsanordnung 1 der Figur 1 eine zweite Leiterplatte 7 angeordnet. Auf der zweiten Leiterplatte 7 ist ein Trusted Platform Module TPM gemäß dem TCG-Standard angeordnet. Zusammen bilden die zweite Leiterplatte 7 und das Trusted Platform Module TPM ein Sicherheitsmodul 8. Selbstverständlich können auch zusätzliche oder andere Komponenten zur Sicherung eines Gerätes Verwendung finden. Das Trusted Platform Module TPM ist mit der zweiten Leiterplatte 7 fest verbunden, beispielsweise auf diese aufgeklebt oder aufgelötet.

Die zweite Leiterplatte 7 mit dem Trusted Platform Module TPM ist durch den Steckverbinder 5 elektrisch und mechanisch an die erste Leiterplatte 2 gekoppelt. Auf diese Weise können Daten zwischen dem Sicherheitsmodul 8 und dem Zentralprozessor 3 ausgetauscht werden, beispielsweise um von dem Zentralprozessor 3 erzeugte Daten elektronisch zu signieren, zu verschlüsseln oder zu verifizieren. Dazu ist in dem Sicherheitsmodul 8 wenigstens ein geheimer Schlüssel gespeichert, der das zu sichernde elektronische Gerät unter anderem eindeutig kennzeichnet.

Um ein Entfernen bzw. Austauschen des Sicherheitsmoduls 8 zu verhindern, ist die zweite Leiterplatte 7 dauerhaft, fest und sicher mit der ersten Leiterplatte 2 verbunden. Hierzu ist ein Befestigungsmittel 9 durch eine Befestigungsöffnung 10 der zweiten Leiterplatte 7 geführt. Das Befestigungsmittel 9 ist mit der Befestigungsvorrichtung 6 der ersten Leiterplatte 2 sicher verbunden.

Die Figuren 2A und 2B zeigen eine erste Ausgestaltung eines zur Befestigung geeigneten Befestigungsmittels 9. Im dargestellten Ausführungsbeispiel handelt es sich bei dem Befestigungsmittel 9 um einen Sicherheitsbefestiger in Form einer mit Klebstoff beschichteten Schraube 11.

In der Figur 2A ist zunächst eine Aufsicht auf eine Schraubenkopf 12 dargestellt. Der Schraubenkopf 12 umfasst eine Vertiefung 13 mit fünf am Rande der Vertiefung 13 gelegenen Einbuchtungen 14. In der Mitte des Schraubenkopfs 12 ist zudem ein Stift 15 angeordnet, der aus der Vertiefung 13 hervortritt. Zum Ein- und Ausdrehen einer Solchen Schraube ist ein Spezialwerkzeug erforderlich, dass in die Einbuchtungen 14 des Schraubenkopf 12 eingreift. Dabei verhindert der Stift 15 die Verwendung eines gewöhnlichen Schraubenziehers. Solche Spezialwerkzeuge werden nur an bestimmte Unternehmen abgegeben und stehen daher nicht allgemein zur Verfügung.

Figur 2B zeigt die Verbindung der Schraube 11 mit einer Befestigungsvorrichtung 6 in Form eines Abstandshalters 16. Um die Verbindung zwischen der Schraube 11 und dem Abstandshalter 16 noch besser zu sichern, ist auf das Gewinde 17 der Schraube 11 eine erste und eine zweite Komponente eines Zweikomponentenklebers in Form mikroskopischer Kugeln 18 aufgetragen. Beim Eindrehen der Schraube 11 in ein Gegengewinde 19 des Abstandshalters 16 werden die mikroskopischen Kugeln 18 zerquetscht, sodass sich die zwei Komponenten des Zweikomponentenklebers miteinander vermischen. Im eingeschraubten Zustand bilden sie somit eine Klebstoffschicht 20 zwischen dem Gewinde 17 und dem Gegengewinde 19 und verhindern ein Lösen der Schraube 11 nach Abbinden des Klebstoffs. Eine solche mit Klebstoff beschichtete Schraube ist beispielsweise aus der europäischen Patentschrift EP 0 483 318 B1 bekannt.

Die Figuren 3A und 3B zeigen ein alternatives Befestigungsmittel 9 in Form eines weiteren Sicherheitsbefestigers. Auch der Sicherheitsbefestiger gemäß den Figuren 3A und 3B ist in Form einer Schraube 11 mit einem Schraubenkopf 12 ausgestaltet. Dabei besteht der Schraubenkopf 12 im Wesentlichen aus zwei gegeneinander verschränkten Halbkreisflächen. Die genaue Struktur des Schraubenkopfs 12 ergibt sich insbesondere aus den in der Figur 3B dargestellten Schnitten B-B, C-C sowie D-D. Im in der Figur 3A oberen bzw. unteren Bereich des Schraubenkopfes 12 tritt die rechte bzw. die linke Halbkreisfläche gegenüber der jeweils daneben liegenden Halbkreisfläche hervor. Somit ist ein Eindrehen der Schraube 11 mittels eines gewöhnlichen Schlitzschraubenziehers im Uhrzeigersinn möglich. Im umgekehrten Drehsinn ist jedoch keine Kraftübertragung möglich, da ein entsprechender Kraftangriff fehlt. Somit kann die Schraube 11 gemäß Figur 3A zwar problemlos in einen Abstandshalter 16 eingeschraubt werden, aus diesem jedoch nicht wieder ohne großen Aufwand entfernt werden.

Selbstverständlich können auch andere Schraubenköpfe mit einem einseitigen Kraftangriff Verwendung finden. Beispielsweise kann ein Kopf einer Schraube so ausgestaltet werden, dass er in einer ersten Drehrichtung vier Flächen für einen Kraftangriff mit einem Kreuzschlitzschraubendreher aufweist und in einer umgekehrten Drehrichtung keine Kraftangriffsflächen aufweist. Bei dem Schraubenkopf 12 gemäß Figur 2A können die Einbuchtungen 14 des Schraubenkopfs 12 ebenfalls rastenförmig ausgestaltet werden, so dass ein Kraftangriff nur in einer ersten Richtung zum Eindrehen der Schraube 11 möglich ist.

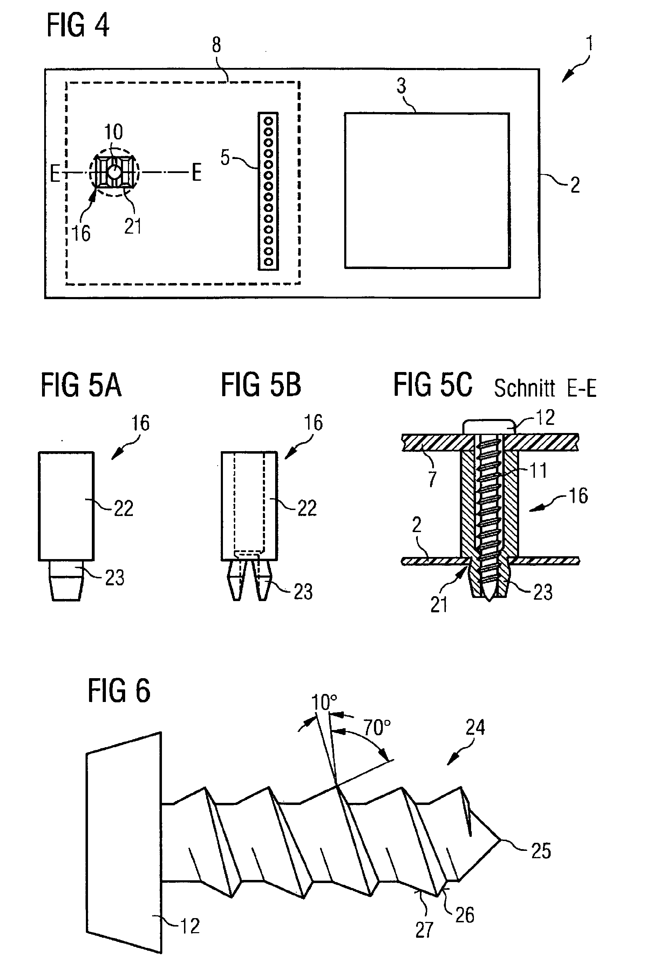

Figur 4 zeigt ein zweites Ausführungsbeispiel einer Befestigungsanordnung 1. Auf einer ersten Leiterplatte 2 ist wiederum ein Zentralprozessor 3 angeordnet. Darüber hinaus ist auf der ersten Leiterplatte 2 ein vierzehnpoliger Steckverbinder 5 angeordnet. Des Weiteren verfügt die erste Leiterplatte 2 über eine rechteckförmige Aussparung 21. Die rechteckige Aussparung 21 dient zum Einsetzen eines nachfolgend beschriebenen und in der Figur 4 gestrichelt dargestellten Kunststoffabstandshalters 16. Über der ersten Leiterplatte 2 kann ein in der Figur 4 gestrichelt dargestelltes Sicherheitsmodul 8, beispielsweise in Form einer zweiten Leiterplatte 7, mit einer Befestigungsöffnung 10 angeordnet werden.

In der Figur 4 sind der Steckverbinder 5 und die Aussparung 21 zur Aufnahme des Abstandshalter 16 auf gegenüberliegenden Seiten des Sicherheitsmoduls 8 angeordnet. Dies ermöglich insbesondere bei räumlich ausgedehnten Sicherheitsmodulen 8 eine mechanisch stabile Befestigung. Selbstverständlich können der Steckverbinder 5 und eine Sicherungsvorrichtung 6 jedoch auch in räumlicher Nähe zueinander angeordnet sein, um die Steckverbindung 5 selbst gegen ein Trennen zu sichern. Darüber hinaus kann eine Befestigungsöffnung 10 eines Sicherheitsmoduls 8 durch ein Trusted Platform Module TPM selbst hindurch geführt werden, um eine besonders starke Sicherung zu bewirken und auch ein Auslöten des Trusted Platform Modules TPM von einer zweiten Leiterplatte 7 zu verhindern.

In den Figuren 5A bis 5C ist der Abstandshalter 16 gemäß Figur 4 detailliert dargestellt. Er besteht im Wesentlichen aus einer Distanzhülse 22, die den Abstand zwischen der ersten Leiterplatte 2 und der zweiten Leiterplatte 7 festlegt und im Wesentlichen der Höhe des Steckverbinders 5 entspricht. Darüber hinaus umfasst der Abstandshalter 16 einen Spreizkopf 23 zum Einstecken in die Aussparung 21 der ersten Leiterplatte 2.

Die Figur 5A zeigt eine erste Aufsicht des Abstandshalters 16, während die Figur 5B zweite, gegenüber der ersten Aufsicht um 90 Grad gedrehte Aufsicht auf den Abstandshalter 16 zweit. In der Figur 5B ist der Spreizkopf 23 im bereits gespreizten Zustand darstellt. Der Spreizkopf 23 wird dadurch gespreizt, dass ein Befestigungsmittel 9, beispielsweise eine Schraube 11, durch die Distanzhülse 22 geführt wird und an deren unteren Ende einen Druck auf den Spreizkopf 23 ausübt. Ein Schnitt E-E durch eine komplette Anordnung mit einer durch die Distanzhülse 22 geführten Schraube 11 ist in der Figur 5C dargestellt.

In dem dargestellten Ausführungsbeispiel ist die Härte des Kunststoffs des Abstandshalters 16 dabei so gewählt, dass sie beim Eindrehen der Schraube 11 in den Abstandshalter 16 genügt, um ein Durchdrehen des Abstandshalters 16 in der rechteckigen Aussparung 21 zu verhindern. Bei einem versuchten Ausdrehen der Schraube 11 aus dem Abstandshalter 16 dreht der Abstandshalter 16 in der Aussparung 21 jedoch durch.

Dies kann beispielsweise dadurch bewirkt werden, dass die Schraube 11, wie oben beschrieben, beim Eindrehen mit dem Abstandshalter 16 verklebt wird. Alternativ kann die Schraube 11 beim Eindrehen auch so fest angezogen werden, dass der Abstandshalter schließlich in der Aussparung 11 durchdreht.

Auf diese Weise wird gewährleistet, dass das Befestigungsmittel 9 dauerhaft mit der Befestigungsvorrichtung 6 verbunden bleibt. Der Versuch des Herausdrehens der Schraube 11 führt somit nicht zum Lösen der Verbindung zwischen der ersten Leiterplatte 2 und der zweiten Leiterplatte 7.

Figur 6 zeigt eine Aufsicht auf einen weiteren Sicherheitsbefestiger in Form einer Pressschraube 24. Die Pressschraube 24 kann mittels eines geeigneten Werkzeugs in eine Befestigungsvorrichtung 6, beispielsweise in Form eines Gewindes in einem Abstandshalter 16, eingeschraubt werden. Auf Grund einer speziellen Form des Gewindes der Pressschraube 24, kann diese jedoch nicht wieder aus der Befestigungsvorrichtung 6 ausgeschraubt werden. Hierzu weist die Pressschraube 24 eine unterschiedliche Flankensteilheit des Gewindeprofils auf. Insbesondere weist eine zur Schraubenspitze 25 weisende erste Fläche 26 des Gewindeprofils einen verhältnismäßig große Winkel gegenüber der Drehachse der Schraube auf, der beim Eindrehen mit einem Innengewinde der Befestigungsvorrichtung 6 zusammenwirkt. Eine in Richtung des Schraubenkopf 12 weisende zweite Fläche 27 des Gewindeprofils ist dagegen flacher ausgestaltet, und bewirkt ein "Durchrutschen" des Gewindegangs bei einem versuchten Ausschrauben. Gleichzeitig verhindert eine konische Form des Schraubenkopfes 12 ein Ausziehen der Pressschraube 24. Eine derartige Verbindung kann nur mittels Presswerkzeug von unten, also aus Richtung der Spitze 25 der Pressschraube 24, gelöst werden.

Es wird darauf hingewiesen, dass die unterschiedlichen hierin beschriebenen Maßnahmen einzeln oder in nahezu jeder beliebiger Kombination verwendet werden können, um einen beabsichtigten Grad der Sicherung herzustellen. Insbesondere kann eine Sicherheit dadurch erhöht werden, dass die Verwendung eines Sicherheitsbefestigers mit gegebenenfalls besonderem Schraubenkopf, einer Verklebung und/oder eines durchdrehenden Abstandshalters 16 miteinander kombiniert werden. Darüber hinaus ist die offenbarte Befestigungsanordnung nicht auf die Befestigung von Leiterplatten innerhalb eines Computersystems beschränkt. Auch andere sicherheitsrelevante Komponenten und Module können an anderen Komponenten eines zu sichernden Geräts wie beschrieben festgelegt werden.

### Bezugszeichenliste

- 1: Befestigungsanordnung
- 2: erste Leiterplatte
- 3: Zentralprozessor
- 4: Sockel
- 5: Steckverbinder
- 6: Befestigungsvorrichtung
- 7: zweite Leiterplatte
- 8: Sicherheitsmodul
- 9: Befestigungsmittel
- 10: Befestigungsöffnung
- 11: Schraube
- 12: Schraubenkopf
- 13: Vertiefung
- 14: Einbuchtung
- 15: Stift
- 16: Abstandshalter
- 17: Gewinde
- 18: Kugeln
- 19: Gegengewinde
- 20: Klebstoffschicht
- 21: Aussparung
- 22: Distanzhülse
- 23: Spreizkopf
- 24: Pressschraube
- 25: Schraubenspitze
- 26: erste Fläche
- 27: zweite Fläche
- TPM: Trusted Platform Module

## Patentansprüche

1. Befestigungsanordnung (1), umfassend
- eine Systemkomponente eines zu sichernden elektronischen Gerätes mit wenigstens einem Steckverbinder (5) und wenigstens einer Befestigungsvorrichtung (6),
- ein in dem Steckverbinder (5) aufgenommenes Sicherheitsmodul (8) mit wenigstens einer Befestigungsöffnung (10), wobei das Sicherheitsmodul (8) das zu sichernde elektronische Gerät eindeutig kennzeichnet, und
- ein durch die Befestigungsöffnung (10) geführtes Befestigungsmittel (9), das durch eine gesicherte Verbindung mit der Befestigungsvorrichtung (6) verbunden ist, wobei das Befestigungsmittel (9) einen Sicherheitsbefestiger umfasst und zumindest zum Lösen des Sicherheitsbefestigers ein Spezialwerkzeug erforderlich ist.

2. Befestigungsanordnung (1) nach Anspruch 1,
**dadurch gekennzeichnet, dass**
die Systemkomponente eine erste Leiterplatte (2) mit einem darauf angeordneten Zentralprozessor (3) umfasst.

3. Befestigungsanordnung (1) nach Anspruch 2,
**dadurch gekennzeichnet, dass**
die erste Leiterplatte (2) eine Aussparung (21) aufweist und die Befestigungsvorrichtung (6) einen durch die Aussparung (21) geführten Abstandshalter (16) umfasst.

4. Befestigungsanordnung (1) nach Anspruch 3,
**dadurch gekennzeichnet, dass**
der Abstandshalter (16) derart ausgestaltet ist, dass er bei einem Eindrehen des Befestigungsmittel (9) in den Abstandshalter (16) in der Aussparung (21) blockiert wird und bei einem Versuch eines Ausdrehens des Befestigungsmittels (9) aus dem Abstandshalter (16) in der Aussparung (21) durchdreht, sodass ein Lösen des Befestigungsmittels (9) aus dem Abstandshalter (16) verhindert wird.

5. Befestigungsanordnung (1) nach Anspruch 4,
**dadurch gekennzeichnet, dass**
die Aussparung (21) wenigstens eine erste Abflachung aufweist und der Abstandshalter (16) wenigstens eine zweite Abflachung aus einem verformbaren Kunststoffmaterial aufweist, wobei die erste Abflachung mit der zweiten Abflachung beim Eindrehen des Befestigungsmittels (9) mit einer ersten Kraft zusammenwirkt, sodass der Abstandshalter (16) in der Aussparung (21) blockiert wird, und das Kunststoffmaterial sich unter Einwirkung einer zum Ausdrehen des Befestigungsmittels (9) erforderlichen zweiten Kraft verformt, sodass der Abstandshalter (16) in der Aussparung (21) durchdreht.

6. Befestigungsanordnung (1) nach einem der Ansprüche 1 bis 5, **dadurch gekennzeichnet, dass**
das Sicherheitsmodul (8) eine zweite Leiterplatte (7) mit einem darauf angeordneten und verlöteten Trusted Platform Module (TPM) umfasst.

7. Befestigungsanordnung (1) nach einem der Ansprüche 1 bis 6, **dadurch gekennzeichnet, dass**
der Sicherheitsbefestiger eine Schraube (11) mit einem einseitigen Krafteingriff umfasst, wobei der einseitige Krafteingriff ein Einschrauben der Schraube (11) in die Befestigungsvorrichtung (6) ermöglicht und ein Lösen der Schraube (11) aus der Befestigungsvorrichtung (6) verhindert.

8. Befestigungsanordnung (1) nach einem der Ansprüche 1 bis 6, **dadurch gekennzeichnet, dass**
der Sicherheitsbefestiger eine Pressschraube umfasst, wobei eine asymmetrische Gewindeform der Pressschraube ein Einschrauben der Pressschraube (11) in die Befestigungsvorrichtung (6) ermöglicht und ein Lösen der Schraube (11) aus der Befestigungsvorrichtung (6) verhindert.

9. Befestigungsanordnung (1) nach einem der Ansprüche 1 bis 8, **dadurch gekennzeichnet, dass**
das Befestigungsmittel (9) und die Befestigungsvorrichtung (6) miteinander verklebt sind.

## Claims

1. Attachment arrangement (1) comprising
- a system component of an electronic appliance to be secured having at least one plug connector (5) and at least one attachment apparatus (6),
- a security module (8) which is accommodated in the plug connector (5) and has at least one attachment opening (10), with the security module (8) uniquely identifying the electronic appliance to be secured, and
- an attachment means (9), which is passed through the attachment opening (10) and is connected by secure connection to the attachment apparatus (6), wherein the attachment means (9) comprises a security attachment means, and a special tool is required at least to release the security attachment means.

2. Attachment arrangement (1) according to Claim 1, **characterized in that** the system component comprises a first printed circuit board (2) having a central processor (3) arranged on it.

3. Attachment arrangement (1) according to Claim 2, **characterized in that** the first printed circuit board (2) has a cutout (21), and the attachment apparatus (6) comprises a spacer (16) which is passed through the cutout (21).

4. Attachment arrangement (1) according to Claim 3, **characterized in that** the spacer (16) is designed such that it is blocked in the cutout (21) when the attachment means (9) is screwed into the spacer (16), and turns freely in the cutout (21) if an attempt is made to unscrew the attachment means (9) out of the spacer (16), thus preventing the attachment means (9) from being released from the spacer (16).

5. Attachment arrangement (1) according to Claim 4, **characterized in that** the cutout (21) has at least one first flat, and the spacer (16) has at least one second flat composed of deformable plastic material, wherein the first flat interacts with the second flat with a first force when the attachment means (9) is being screwed in, such that the spacer (16) is blocked in the cutout (21), and the plastic material is deformed under the influence of a second force, which is required to unscrew the attachment means (9), such that the spacer (16) turns freely in the cutout (21).

6. Attachment arrangement (1) according to one of Claims 1 to 5, **characterized in that** the security module (8) comprises a second printed circuit board (7) with a trusted platform module (TPM) arranged and soldered on it.

7. Attachment arrangement (1) according to one of Claims 1 to 6, **characterized in that** the security attachment means comprises a screw (11) on which force can act in one direction, with the force action in one direction allowing the screw (11) to be screwed into the attachment apparatus (6), and preventing the screw (11) from being released from the attachment apparatus (6).

8. Attachment arrangement (1) according to one of Claims 1 to 6, **characterized in that** the security attachment means comprises a pressing screw, wherein an asymmetric thread form on the pressing screw allows the pressing screw (11) to be screwed into the attachment apparatus (6), and prevents the screw (11) from being released from the attachment apparatus (6).

9. Attachment arrangement (1) according to one of Claims 1 to 8, **characterized in that** the attachment means (9) and the attachment apparatus (6) are adhesively bonded to one another.

## Revendications

1. Système de fixation (1) qui comporte:
- un composant système d'un appareil électronique à protéger, qui présente au moins une fiche de raccordement (5) et au moins un dispositif de fixation (6),
- un module de sécurité (8) logé dans la fiche de raccordement (5) et doté d'au moins une ouverture de fixation (10), le module de sécurité (8) caractérisant de manière univoque l'appareil électronique à protéger et
- un moyen de fixation (9) qui traverse l'ouverture de fixation (10) et qui est relié par une liaison sécurisée au dispositif de fixation (6), le moyen de fixation (9) comprenant un fixateur de sécurité, un outil spécial étant nécessaire au moins pour libérer le fixateur de sécurité.

2. Système de fixation (1) selon la revendication 1, **caractérisé en ce que** le composant du système comporte une première carte de circuit (2) sur laquelle est disposé un processeur central (3).

3. Système de fixation (1) selon la revendication 2, **caractérisé en ce que** la première carte de circuit (2) présente une découpe (21) et **en ce que** le dispositif de fixation (6) comporte un écarteur (16) qui traverse la découpe (21).

4. Système de fixation (1) selon la revendication 3, **caractérisé en ce que** l'écarteur (16) est configuré de telle sorte que le moyen de fixation (9) est bloqué dans la découpe (21) lorsqu'il est vissé dans l'écarteur (16) et que lorsque l'on tente de dévisser le moyen de fixation (9) hors de l'écarteur (16), il tourne à travers la découpe (21) de manière à empêcher que le moyen de fixation (9) soit détaché de l'écarteur (16).

5. Système de fixation (1) selon la revendication 4, **caractérisé en ce que** la découpe (21) présente au moins un premier méplat et **en ce que** l'écarteur (16) présente au moins un deuxième méplat en matière synthétique déformable, le premier méplat coopérant avec le deuxième méplat lorsque le moyen de fixation (9) est vissé avec une première force de telle sorte que l'écarteur (16) soit bloqué dans la découpe (21) et **en ce que** la matière synthétique se déforme sous l'action d'une deuxième force nécessaire pour dévisser le moyen de fixation (9), de sorte que l'écarteur (16) tourne en traversant la découpe (21).

6. Système de fixation (1) selon l'une des revendications 1 à 5, **caractérisé en ce que** le module de sécurité (8) comporte une deuxième carte de circuit (7) sur laquelle sont disposés et brasés des modules de plateforme sécurisés ("Trusted Platform Module" - TPM).

7. Système de fixation (1) selon l'une des revendications 1 à 6, **caractérisé en ce que** le fixateur de sécurité comporte une vis (11) sur un côté de laquelle une force peut agir, l'action de la force sur un côté permettant de visser la vis (11) dans le dispositif de fixation (6) et empêchant que la vis (11) se libère du dispositif de fixation (6).

8. Système de fixation (1) selon l'une des revendications 1 à 6, **caractérisé en ce que** le fixateur de sécurité comporte une vis de poussée, un filet de forme asymétrique de la vis de poussée permettant de visser la vis de poussée (11) dans le dispositif de fixation (6) et empêchant que la vis (11) se détache du dispositif de fixation (6).

9. Système de fixation (1) selon l'une des revendications 1 à 8, **caractérisé en ce que** le moyen de fixation (9) et le dispositif de fixation (6) sont collés l'un sur l'autre.
